# FASCICULE DE BREVET EUROPEEN

(11) **EP 2 866 173 B1**
(45) Date de publication et mention de la délivrance du brevet: **29.08.2018**
(21) Numéro de dépôt: 14190112.4
(22) Date de dépôt: 23.10.2014
(51) Int. Cl.: G06K 19/077

(54) **Procédé de réalisation d'un circuit électrique et circuit électrique réalisé par ce procédé**
Verfahren zur Erzeugung eines elektrischen Schaltkreises, und mit diesem Verfahren erzeugter Schaltkreis
Method for manufacturing an electric circuit and electric circuit manufactured by said method

(30) Priorité: 25.10.2013 FR 1360469
(43) Date de publication de la demande: 29.04.2015
(73) Titulaire: Linxens Holding, 78200 Mantes-la-Jolie (FR)
(72) Inventeur: Hoveman, Bertrand, 95610 Eragny-sur-Oise (FR); Welsch, Pierre-Alois, 75015 Paris (FR)
(74) Mandataire: GIE Innovation Competence Group

(56) Documents cités:
- EP-A1- 1 172 760
- WO-A1-2014/068145
- WO-A1-2014/191428
- US-A- 5 255 430
- US-A1- 2002 053 735
- US-A1- 2011 011 939

## Description

L'invention concerne le domaine des circuits électriques double face, et notamment celui des circuits électriques double face flexibles. Par exemple, des circuits électriques selon l'invention peuvent être utilisés pour la réalisation de modules électroniques de carte à puce « dual », c'est-à-dire comprenant des contacts sur une face et une antenne sur une autre face ou encore comprenant des contacts sur une face et des moyens de connexion, sur une autre face, avec une antenne située dans le corps d'une carte à puce.

Les documents US20110011939A1 et US20020053735A1, ainsi que les documents intercalaires WO2014068145A1 et WO2014191428A1, divulguent divers procédés de réalisation de ce type de carte à puce.

De telles cartes à puce « dual » ont de multiples usages : cartes de crédit, cartes de transport, cartes d'identité, etc. Celles-ci sont généralement constituées d'un support rigide, par exemple en matière plastique, constituant l'essentiel de la carte, dans lequel est incorporé un module électronique fabriqué séparément et une antenne. Le module électronique comporte un circuit électrique généralement flexible, muni d'une puce (circuit intégré), avec des plages de contact sur une face, dite face contact ou face avant et qui est visible sur la carte une fois celle-ci finie, et sur la face opposée, dite face arrière ou face de connexion, des plages conductrices (par exemple en cuivre) intégrant directement une antenne pour les cartes « dual » à effet « booster » ou bien intégrant des plots de connexion avec une antenne qui est localisée uniquement dans le corps de la carte.

Selon l'exemple choisi pour illustrer l'invention, les cartes à puce concernées ont donc une double interface de communication avec la puce (d'où le terme « dual »). On parle aussi de cartes avec et sans contact, ou de cartes « Combi ».

Pour une utilisation « avec contact», les contacts sont reliés à la puce et affleurent sur la face avant du module pour permettre une connexion électrique à un dispositif de lecture et/ou écriture, lors de l'introduction de la carte dans ce dispositif.

Pour une utilisation « sans contact », on utilise, sur la face arrière du module :
- soit une antenne qui est directement et physiquement électriquement connectée à la puce, et couplée électro-magnétiquement (donc sans liaison physique) avec une deuxième antenne, dite « antenne booster ou master », incorporée dans le support rigide de la carte ;
- soit des plots de connexion, appelées aussi « pads » qui sont connectés physiquement avec une antenne incorporée dans le support rigide de la carte.

Les contacts, tout comme l'antenne, sont réalisés à partir d'un matériau conducteur.

Il existe plusieurs techniques pour définir des motifs de contacts, des plots de connexion ou d'antennes dans une couche de matériau conducteur. Par exemple, les motifs peuvent être découpés dans une feuille de cuivre avant que celle-ci ne soit colaminée sur un substrat isolant. La technique correspondante consiste à découper des motifs (aussi appelé « grilles ») dans une feuille métallique. Cette technique est communément appelée technologie « lead frame » (voir par exemple le document EP1785916B1). Les motifs peuvent également être gravés (photolithogravure) dans une feuille de cuivre préalablement colaminée sur un substrat isolant.

Selon l'invention, il est proposé un procédé de fabrication d'un circuit électrique selon la revendication 1
dans lequel on fournit un substrat de matériau diélectrique ayant une première et une deuxième faces principales. Par exemple, le substrat est constitué d'un ruban de matériau isolant tel que du verre époxy. Selon ce procédé sont réalisées également une première piste électriquement conductrice sur la première face et une deuxième piste électriquement conductrice sur la deuxième face. Au moins un trou traversant est réalisé à travers le substrat pour permettre une connexion électrique entre les pistes conductrices des première et deuxième faces principales du substrat. Au moins l'une des première et deuxième pistes conductrices est prédécoupée dans une couche conductrice et collée à l'aide d'une couche d'adhésif présente sur l'une des première et une deuxième faces principales du substrat et perforée en coïncidence du trou traversant le substrat. Ainsi par exemple, tandis qu'une deuxième piste conductrice prédécoupée est collée sur la deuxième face principale du substrat, une première piste conductrice est gravée dans une première couche conductrice colaminée sur la première face principale du substrat. Cette première couche conductrice est par exemple constituée d'une feuille de cuivre gravée pour définir les motifs d'une antenne ou de plots de connexion d'une antenne. On réalise alors un trou traversant à la fois le substrat isolant et la première couche conductrice. Par ailleurs, on pré-découpe dans une deuxième couche conductrice, par exemple par la technologie « lead frame », une grille comportant au moins la deuxième piste conductrice prédécoupée, que l'on reporte ensuite sur la deuxième face du substrat (opposée à la première face).

Ainsi, il est possible de sélectionner les première et deuxième couches conductrices spécifiquement en fonction de la nature des motifs conducteurs qui doivent y être réalisés.

Par exemple, si la première couche conductrice doit fournir une ou plusieurs antennes ou plots de connexion d'antenne, au moins une piste conductrice correspondant à de tels motifs, est gravée dans la première couche conductrice préalablement collée et/ou colaminée sur un substrat isolant. Cette étape de gravure est réalisée, préalablement à l'étape consistant à reporter sur la deuxième face du substrat isolant, la deuxième couche conductrice comportant au moins une piste conductrice prédécoupée.

Par exemple, cette piste conductrice prédécoupée comporte des contacts réalisés dans la deuxième couche conductrice par la technologie « lead frame ». Les contacts ainsi prédécoupés sont reportés et colaminés sur la face opposée du substrat isolant à celle comportant les antennes ou plots d'antenne gravés.

Si une puce est accueillie, soit sur la face arrière du substrat (opposée à la face avant ou face contact), soit dans une cavité réalisée dans ce substrat, celle-ci doit être connectée à la face arrière des contacts, par exemple avec des fils conducteurs (c'est à dire selon la technique dite de «wire bonding » selon la terminologie anglo-saxonne). Pour permettre cette connexion des fils conducteurs sur la face arrière de la première piste conductrice, la couche d'adhésif déposée sur la deuxième face principale du substrat, préalablement au report sur celle-ci de la deuxième piste conductrice pré-découpée, est perforée en coïncidence du trou traversant le substrat.

De même, afin d'assurer une qualité suffisante à cette connexion, sur la face arrière du matériau de la première couche conductrice, on prévoit alors une étape de dépôt sélectif (ou dépôt et gravure sélective) d'un deuxième matériau conducteur sur au moins une zone de soudure localisée sur une face de la deuxième couche conductrice. Ce deuxième matériau conducteur est choisi pour ses propriétés conductrices et/ou de résistance à la corrosion. Il s'agit généralement d'un métal précieux tel que de l'or ou une bicouche palladium sur or. En faisant coïncider au moins une zone de soudure localisée avec le trou traversant le substrat, on peut venir souder une extrémité d'un fil conducteur sur la zone de soudure localisée, tandis que l'autre extrémité est connectée à la puce.

Dans le but d'améliorer la qualité des contacts, le dépôt du deuxième matériau conducteur peut d'ailleurs être aussi réalisé sur une face de la deuxième couche conductrice, opposée à la face comportant la zone de soudure localisée.

Selon un autre exemple, une première et une deuxième pistes conductrices, chacune respectivement pré-découpée dans une couche de matériau électriquement conducteur, sont chacune respectivement collée sur la première et la deuxième faces principales du substrat.

Selon un autre aspect, l'invention concerne un circuit électrique selon la revendication 10 pour la réalisation
d'au moins une carte à puce, comprenant un substrat comportant une première couche conductrice sur une première face et une deuxième couche conductrice sur une deuxième face, les première et deuxième faces comportant chacune respectivement au moins une piste conductrice.

Par exemple, là où les pistes conductrices de la première face correspondent à une ou plusieurs antennes, tandis que la ou les pistes conductrices de la deuxième face correspondent à un ou plusieurs contacts.

Le circuit électrique comporte alors, par exemple, sur la première face, une piste conductrice gravée dans la première couche de matériau conducteur et, sur la deuxième face, une piste conductrice prédécoupée dans la deuxième couche de matériau conducteur.

Le circuit électrique peut aussi comporter deux pistes conductrices prédécoupées et collées à l'aide d'une couche d'adhésif, chacune respectivement sur l'une des faces principales du substrat.

Dans tous les cas, la couche d'adhésif se trouve en coïncidence du trou traversant le substrat.

L'invention concerne également un procédé et un circuit comportant en outre l'une ou l'autre des caractéristiques mentionnées dans les revendications 1 à 14 considérées isolément ou en combinaison.

D'autres caractéristiques et avantages de l'invention apparaîtront à la lecture de la description détaillée et des dessins annexés sur lesquels :
- La figure 1 représente schématiquement en perspective une carte à puce destinée à recevoir un circuit électrique selon l'invention ;
- Les figures 2A à 2J représentent schématiquement les différentes étapes d'un exemple de procédé conforme à l'invention ;
- Les figures 3A à 3E représentent schématiquement les différentes étapes d'un autre exemple de procédé conforme à l'invention ; et
- Les figures 4A à 4D représentent schématiquement les différentes étapes d'encore un autre exemple de procédé conforme à l'invention.

Un exemple de mise en oeuvre du procédé selon l'invention est décrit ci-dessous. Selon cet exemple, il s'agit d'un procédé de fabrication d'un circuit électrique pour module de carte à puce.

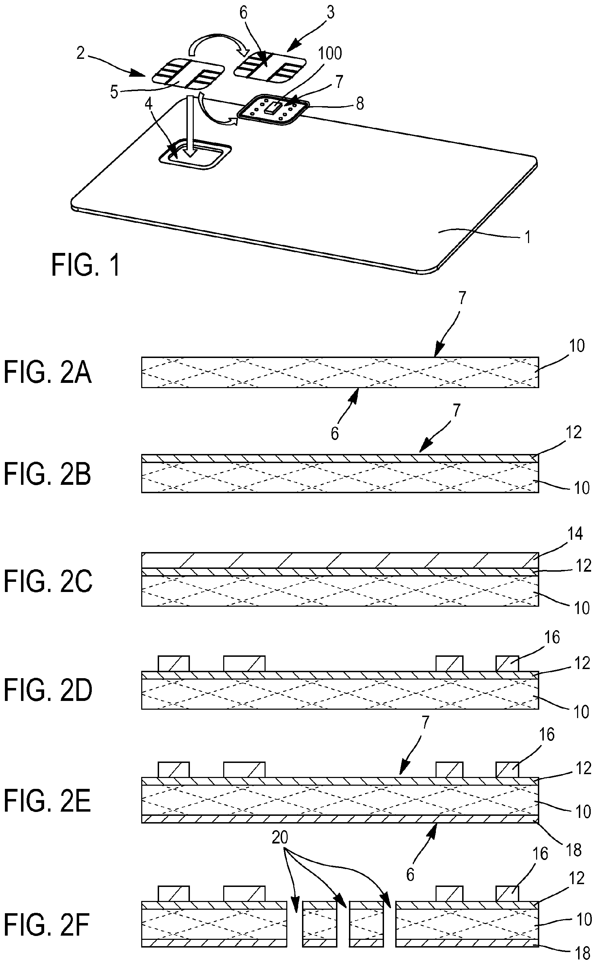

Comme représenté sur la figure 1, une carte à puce 1 comporte un module 2. Le module 2 comprend un circuit électrique 3 et une puce 100. Le module 2 est généralement réalisé sous forme d'un élément séparé qui est inséré dans une cavité 4 ménagée dans la carte 1.

Le circuit électrique 3 comporte plusieurs contacts 5 auxquels est connectée la puce 100. Le circuit électrique 3 est représenté (en haut) vu par sa face avant 6 (face contact). Il est aussi représenté (en bas) vu par sa face arrière 7. Le circuit électrique 3 représenté correspond à un circuit imprimé double face pour carte « dual », avec des contacts 5 sur la face avant 6 et, sur la face arrière 7, une antenne 8 ou des plots de contact pour la connexion à une antenne localisée dans le reste la carte 1.

Sur la figure 2A est représentée une étape du procédé de fabrication du circuit électrique 3. À cette étape, on fournit un substrat 10 flexible, par exemple de verre-epoxy. Le substrat 10 fait par exemple entre 50 et 150µm d'épaisseur et fait préférentiellement 110µm d'épaisseur. Le substrat 10 comporte une première face principale (correspondant ici à la face avant 6) et une deuxième face principale (correspondant ici à la face arrière 7).

L'étape représentée sur la figure 2B consiste à réaliser une première couche d'adhésif 12 sur la face arrière 7 du substrat 10. Cette première couche d'adhésif 12 peut être réalisée de manière connue, par enduction ou colamination d'un film d'adhésif. La face du substrat 10 sur laquelle a été déposée la couche d'adhésif 12 reçoit alors une première couche conductrice 14 (figure 2C). Cette première couche conductrice 14 est par exemple constituée d'une feuille de cuivre dont l'épaisseur est par exemple voisine de 35µm.

En variante, l'ensemble ainsi constitué du substrat 10 et de la première couche conductrice 14 est un complexe (« copper clad » selon la terminologie anglo-saxonne) dans lequel le substrat 10 et la première couche conductrice 14 sont directement en contact l'un sur l'autre, sans couche d'adhésif 12 entre les deux. Dans ce cas, la suite du procédé est identique à ce qui va être décrit, sans la couche d'adhésif 12 sur les figures.

L'ensemble ainsi constitué du substrat 10 et de la première couche conductrice 14 subit un ensemble d'opérations (non représentées) permettant de réaliser par photo lithogravure au moins une première piste conductrice 16 destinée à constituer une ou plusieurs antennes (figure 2D) et/ou un ou plusieurs plots de connexion d'une antenne (par soucis de simplification, seul le terme d'antenne sera utilisé dans la suite pour une antenne ou un plot d'antenne). L'ensemble de ces étapes comporte avantageusement la réalisation d'une couche de finition. Une telle couche de finition comporte par exemple une couche de nickel, elle-même recouverte d'or et/ou de palladium.

L'étape représentée sur la figure 2E consiste à réaliser une deuxième couche d'adhésif 18 sur la face arrière 6 du substrat 10. Cette deuxième couche d'adhésif 18 peut être réalisée de manière connue par enduction ou colamination d'un film d'adhésif.

Cette étape peut éventuellement être sous-traitée. Elle est avantageusement réalisée après les étapes mentionnées plus haut de photo-lithogravure et de réalisation de la couche de finition. Ainsi, en effet l'adhésif ne nécessite pas de protection, sauf éventuellement s'il y a sous-traitance, transport, etc.

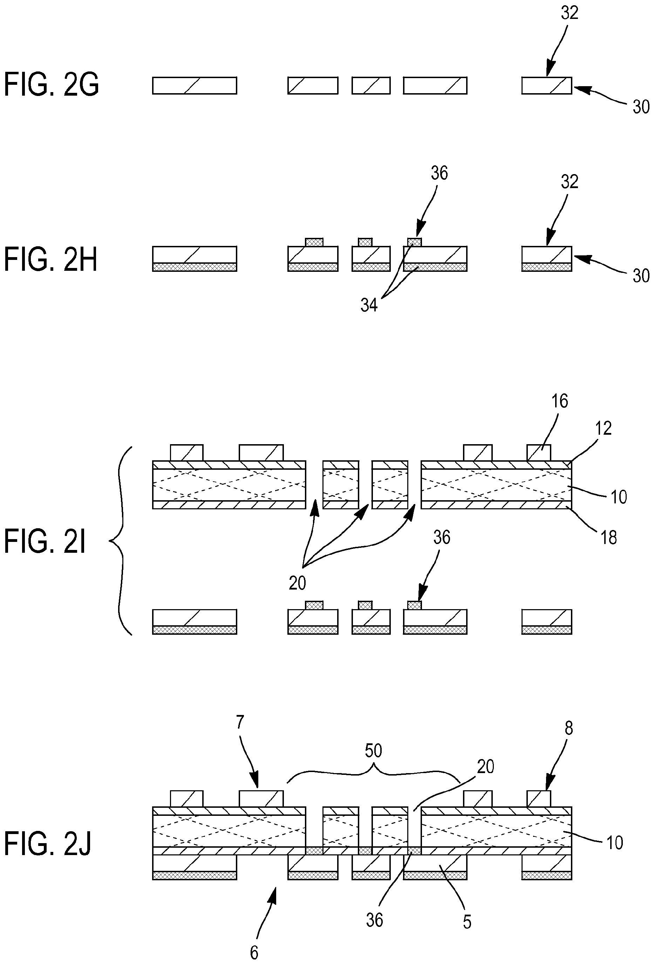

L'ensemble obtenu à l'étape précédente est alors perforé de manière à réaliser des trous 20 traversant la totalité de son épaisseur (figure 2F). En variante, cette étape de perforation peut être réalisée, en ligne, avec un outil adapté, au cours de l'étape de colamination décrite ci-dessous en relations avec la figure 2I. Dans ce cas, cet outil réalise les perforations juste avant de colaminer l'ensemble de la figure 2E avec une deuxième couche conductrice 30.

Par ailleurs, et de manière indépendante, une deuxième couche conductrice 30 est préparée (figure 2G). Celle-ci est découpée de manière à réaliser au moins une deuxième piste conductrice 32 destinée à constituer des contacts 5. Chacune des deuxièmes pistes conductrices 32 correspond à une grille découpée (« lead frame » selon la terminologie anglo-saxonne). La deuxième couche conductrice 30 dans laquelle sont découpées les deuxièmes pistes conductrices 32 est par exemple constituée d'une feuille de cuivre dont l'épaisseur est voisine de 70 microns et est préférentiellement comprise entre 18 et 100µm.

Afin de les protéger d'une part et d'en améliorer la performance électrique d'autre part, les pistes conductrices 32 reçoivent une couche de finition constituée par exemple d'un deuxième matériau conducteur 34 tel que du nickel et de l'or, sur chacune de leur face. Cette couche de finition est réalisée de manière sélective afin que l'or ne recouvre que des zones qui correspondent chacune respectivement à une zone de soudure localisée 36 (figure 2H). D'autres métaux précieux que l'or peuvent être utilisés. Ainsi, de l'argent, du platine, du nickel, du palladium, du ruthénium, du rhodium, ou leurs alliages peuvent être déposés par électrodéposition pour couvrir, en tout ou partie, les faces principales de la deuxième couche conductrice 30. Afin de limiter la quantité de métal précieux électro-déposé, un masquage mécanique peut être mis en oeuvre dans une cellule d'électrolyse.

Comme représenté sur la figure 2I, les complexes représentés respectivement aux figures 2F et 2H sont colaminés en faisant coïncider les zones de soudure localisées 36 chacune respectivement avec les trous traversants 20.

Le résultat de cette opération est représenté à la figure 2J. Il s'agit d'une structure comportant un substrat 10, une piste conductrice, telle qu'une antenne 8, sur sa face arrière 7, et une autre piste conductrice, telle qu'un contact 5, sur sa face avant 6. Cette structure comporte également une cavité 50 sur la face arrière 7 du substrat 10, destinée à recevoir une puce 100 (non représentée sur cette figure) qui pourra être connectée à la face arrière des contacts 5 à l'aide de fils conducteurs passant à travers des trous traversants 20 et soudés sur les zones de soudure localisées 36.

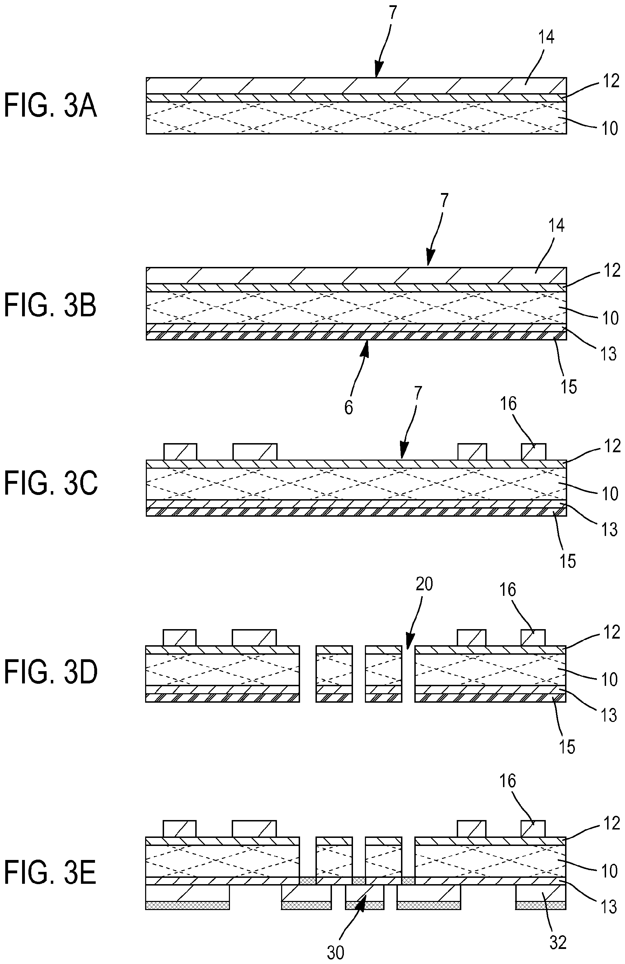

Selon un autre exemple de procédé selon l'invention, représenté sur les figures 3A à 3E, on fournit un substrat 10 muni d'une première couche d'adhésif 12 sur la face arrière 7 sur laquelle est reportée une première couche conductrice 14 (voir Fig. 3A). Ce substrat est semblable à celui décrit en relation avec la figure 2B.

En variante, il est possible de partir directement d'un « copper clad », sans couche d'adhésif 12 entre le substrat 10 et la première couche conductrice 14, comme mentionné en relation avec le mode de réalisation des figures 2A à 2J.

Comme représenté à la figure 3B, la face avant 6 est ensuite munie d'une deuxième couche d'adhésif 13 protégée par un film antiadhésif 15.

Le complexe ainsi obtenu subit alors des étapes semblables à celles décrites en relation avec la 2D, de manière à réaliser une première piste conductrice 16 gravée dans la première couche conductrice 14, sur la face arrière 7 (voir Fig. 3C).

De manière analogue à l'étape décrite en relation avec la figure 2F, le complexe obtenu à l'étape précédente est perforé de manière à réaliser des trous 20 traversant la totalité de son épaisseur (Fig. 3D).

Le film antiadhésif 15 est alors retiré. Une grille découpée dans une deuxième couche conductrice 30 pour former des deuxièmes pistes conductrices 32, telles que celles obtenues à la figure 2H (avec une couche de finition), est colaminée avec le complexe de la figure 3D. On obtient alors à la figure 3E, un circuit électrique analogue à celui de la figure 2J.

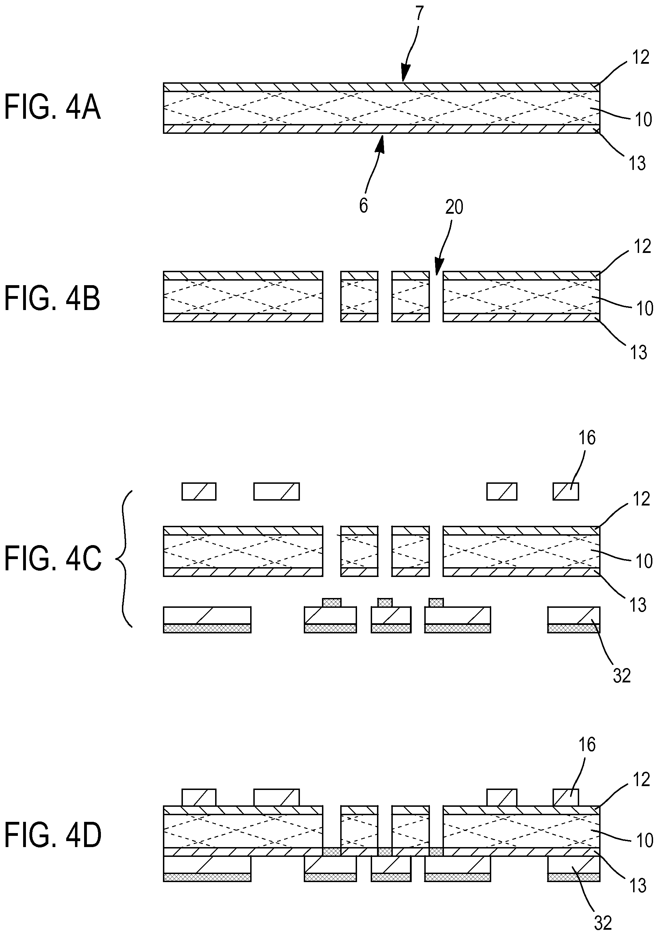

Selon un autre exemple de procédé selon l'invention, représenté sur les figures 4A à 4D, on fournit un substrat 10 muni d'une première 12 et d'une deuxième 13 couches d'adhésif sur les faces avant 6 et arrière 7 (voir Fig. 4A).

De manière analogue à l'étape décrite en relation avec les figures 2F et 3D, le complexe obtenu à l'étape précédente est perforé de manière à réaliser des trous 20 traversant la totalité de son épaisseur (Fig. 4B).

Des grilles sont prédécoupées pour former des premières 16 et deuxièmes 32 pistes conductrices, selon la technologie « lead-frame » décrite ci-dessus, respectivement dans une première et une deuxième couches conductrices. Celles-ci peuvent recevoir une couche de finition comme mentionné ci-dessus, avant d'être colaminées en une étape ou en deux étapes (c'est-à-dire l'une après l'autre) avec le substrat obtenu à l'étape décrite en relation avec la figure 4B.

On obtient alors à la figure 4D, un circuit électrique analogue à celui de la figure 2J ou de la figure 3E, à la différence près que cette fois-ci, les deux faces principales 6, 7 du substrat 10 comportent des pistes conductrices prédécoupées, au lieu de pistes conductrices gravées sur une face et des pistes conductrices prédécoupées sur l'autre.

## Revendications

1. Procédé de fabrication d'un circuit électrique (3) pour la réalisation d'au moins une carte à puce, comprenant
- la fourniture d'un substrat (10) de matériau diélectrique, ne comportant pas de matériau magnétique et ayant une première et une deuxième faces principales (6, 7),
- la réalisation d'une première piste (16) électriquement conductrice sur la première face,
- la réalisation d'une deuxième piste (32) électriquement conductrice sur la deuxième face,
- la réalisation d'au moins un trou (20) traversant le substrat (10),
la deuxième piste (32) électriquement conductrice recevant
une couche de finition, **caractérisé par le fait**
**qu'**au moins l'une des première et deuxième pistes
conductrices (16, 32) est prédécoupée dans une couche conductrice puis collée à l'aide d'une couche d'adhésif (12 ou 13) présente sur l'une des première et une deuxième faces principales (6, 7) du substrat (10) et perforée en coïncidence du trou (20) traversant le substrat (10).

2. Procédé selon la revendication 1, dans lequel la couche d'adhésif (12 ou 13) est perforée concomitamment avec la réalisation du trou (20) traversant le substrat (10).

3. Procédé selon la revendication 1 ou 2, dans lequel la première piste conductrice (16) est réalisée par gravure d'une première couche conductrice préalablement co-laminée sur la première face du substrat et la couche d'adhésif (13) est protégée lors de cette gravure par une pellicule antiadhésive (15).

4. Procédé selon la revendication 3, comportant une étape de dépôt d'une couche de finition sur la première piste conductrice (16) et une étape de retrait de la pellicule antiadhésive (15) postérieurement au dépôt de la couche de finition.

5. Procédé selon la revendication 3 ou 4, dans lequel la première piste conductrice (16) est gravée dans la première couche conductrice (14), préalablement au collage, sur la deuxième face du substrat, de la deuxième piste conductrice (32) qui elle, est prédécoupée dans la couche conductrice.

6. Procédé selon la revendication 1 ou 2, dans lequel la première piste conductrice (16) est réalisée par découpe dans une première couche conductrice avant d'être co-laminée sur la première face du substrat (10).

7. Procédé selon l'une des revendications précédentes, comportant une étape de dépôt d'un deuxième matériau conducteur (34) sur au moins une zone de soudure localisée (36) sur une face d'au moins l'une des première et deuxième pistes conductrices (16, 32).

8. Procédé selon la revendication 7, dans lequel on fait coïncider au moins une zone de soudure localisée (36) avec le trou (20) traversant le substrat.

9. Procédé selon la revendication 7 ou 8, comportant une étape de dépôt du deuxième matériau conducteur (34) sur une face de l'une des première et deuxième pistes conductrices (16, 32), opposée à la face comportant la zone de soudure localisée (36).

10. Circuit électrique pour la réalisation d'au moins une carte à puce (1), comprenant un substrat (10) de matériau diélectrique, ne comportant pas de matériau magnétique et ayant une première et une deuxième faces principales (6, 7), et comportant une première piste électriquement conductrice (16) sur la première face, une deuxième piste électriquement conductrice (32) sur la deuxième face, ayant reçu une couche de finition, et au moins un trou (20) traversant le substrat (10), **caractérisé par le fait qu'**au moins l'une des première et deuxième pistes conductrices (16, 32) est constituée d'une couche conductrice prédécoupée et collée, sur l'une des première et une deuxième faces principales (6, 7) du substrat (10), à l'aide d'une couche d'adhésif (12 ou 13) perforée en coïncidence du trou (20) traversant le substrat (10).

11. Circuit électrique selon la revendication 10, dans lequel un deuxième matériau conducteur (34) est disposé sur au moins une zone de soudure localisée (36) sur une face de la piste conductrice prédécoupée.

12. Circuit électrique selon la revendication 11, dans lequel au moins une zone de soudure localisée (36) se trouve en vis-à-vis du trou (20) traversant le substrat (10).

13. Circuit électrique selon la revendication 11 ou 12, dans lequel la première piste conductrice (16) est gravée dans une première couche conductrice (14).

14. Circuit électrique selon la revendication 11 ou 12, dans lequel les première et deuxième pistes conductrices (16, 32) sont prédécoupées respectivement dans une première et une deuxième couches conductrices.

## Patentansprüche

1. Verfahren zur Herstellung eines elektrischen Schaltkreises (3) zur Erzeugung mindestens einer Chipkarte, umfassend
- das Bereitstellen eines Substrats (10) aus dielektrischem Material, das kein magnetisches Material umfasst und eine erste und eine zweite Hauptfläche (6, 7) aufweist,
- das Erzeugen einer ersten elektrisch leitenden Bahn (16) auf der ersten Seite,
- das Erzeugen einer zweiten elektrisch leitenden Bahn (32) auf der zweiten Seite,
- das Erzeugen mindestens einer Bohrung (20) durch das Substrat (10),
die zweite elektrisch leitende Bahn (32) erhält eine Decklage, **dadurch gekennzeichnet, dass** mindestens eine der ersten und zweiten leitenden Bahnen (16, 32) in einer leitenden Schicht vorgestanzt ist, die dann mithilfe einer Klebstoffschicht (12 oder 13), die auf einer der ersten und zweiten Hauptflächen (6, 7) des Substrats (10) vorhanden ist, geklebt wird und deckungsgleich mit der Bohrung (20) durch das Substrat (10) durchbohrt wird.

2. Verfahren nach Anspruch 1, wobei die Klebstoffschicht (12 oder 13) gleichzeitig mit der Erzeugung der Bohrung (20) durch das Substrat (10) durchbohrt wird.

3. Verfahren nach Anspruch 1 oder 2, wobei die erste leitende Bahn (16) durch Ätzen einer ersten leitenden Schicht erzeugt wird, die zuvor auf die erste Seite des Substrats co-laminiert wurde, und die Klebstoffschicht (13) während dieser Ätzung durch eine Antihaftfolie (15) geschützt wird.

4. Verfahren nach Anspruch 3, umfassend einen Schritt zum Abscheiden einer Decklage auf der ersten leitenden Bahn (16) und einen Schritt zum Abziehen der Antihaftfolie (15) nach der Abscheidung der Decklage.

5. Verfahren nach Anspruch 3 oder 4, wobei die erste leitende Bahn (16) in die erste leitende Schicht (14) geätzt wird, bevor sie auf die zweite Seite des Substrats der zweiten leitenden Bahn (32) geklebt wird, die ihrerseits in die leitende Schicht vorgestanzt wird.

6. Verfahren nach Anspruch 1 oder 2, wobei die erste leitende Bahn (16) durch Stanzen in eine erste leitende Schicht erzeugt wird, bevor sie auf die erste Seite des Substrats (10) co-laminiert wird.

7. Verfahren nach einem der vorhergehenden Ansprüche, umfassend einen Schritt zum Abscheiden eines zweiten leitenden Materials (34) auf mindestens eine örtlich begrenzte Lötfläche (36) auf einer Seite mindestens einer der ersten und zweiten leitenden Bahnen (16, 32).

8. Verfahren nach Anspruch 7, wobei mindestens eine örtlich begrenzte Lötfläche (36) mit der Bohrung (20) durch das Substrat in Deckung gebracht wird.

9. Verfahren nach Anspruch 7 oder 8, umfassend einen Schritt zum Abscheiden des zweiten leitenden Materials (34) auf einer Seite der einen der ersten und zweiten leitenden Bahnen (16, 32) gegenüber der Seite, die die örtlich begrenzte Lötfläche (36) umfasst.

10. Elektrische Schaltung zur Erzeugung mindestens einer Chipkarte (1), umfassend ein Substrat (10) aus dielektrischem Material, das kein magnetisches Material umfasst und eine erste und eine zweite Hauptseite (6, 7) aufweist und eine erste elektrisch leitende Bahn (16) auf der ersten Seite, eine zweite elektrisch leitende Bahn (32) auf der zweiten Seite umfasst, die eine Decklage erhalten hat, und mindestens eine Bohrung (20) durch das Substrat (10), **dadurch gekennzeichnet, dass** mindestens eine der ersten und zweiten leitenden Bahnen (16, 32) aus einer leitenden Schicht besteht, die vorgestanzt und auf eine der ersten und zweiten Hauptseiten (6, 7) des Substrats (10) mithilfe einer Klebstoffschicht (12 oder 13) geklebt wird, die deckungsgleich mit der Bohrung (20) durch das Substrat (10) durchbohrt wird.

11. Elektrischer Schaltkreis nach Anspruch 10, wobei ein zweites leitendes Material (34) auf mindestens einer örtlich begrenzten Lötfläche (36) auf einer Seite der vorgestanzten leitenden Bahn angeordnet wird.

12. Elektrischer Schaltkreis nach Anspruch 11, wobei sich mindestens eine örtlich begrenzte Lötfläche (36) gegenüber der Bohrung (20) durch das Substrat (10) befindet.

13. Elektrischer Schaltkreis nach Anspruch 11 oder 12, wobei die erste leitende Bahn (16) in eine erste leitende Schicht (14) geätzt wird.

14. Elektrischer Schaltkreis nach Anspruch 11 oder 12, wobei die ersten und zweiten leitenden Bahnen (16, 32) jeweils in einer ersten und einer zweiten leitenden Schicht vorgestanzt sind.

## Claims

1. Method for manufacturing an electrical circuit (3) for producing at least one chip card, comprising
- providing a substrate (10) of dielectric material, not including magnetic material and having a first and a second main face (6, 7),
- producing a first electrically conductive track (16) on the first face,
- producing a second electrically conductive track (32) on the second face,
- producing at least one hole (20) passing through the substrate (10),
the second electrically conductive track (32) receiving a finishing layer, **characterized in that** at least one of the first and second conductive tracks (16, 32) is cut out beforehand from a conductive layer and then bonded by way of a layer of adhesive (12 or 13) present on one of the first and second main faces (6, 7) of the substrate (10) and perforated coincidentally with the hole (20) passing through the substrate (10).

2. Method according to Claim 1, wherein the layer of adhesive (12 or 13) is perforated at the same time as the production of the hole (20) passing through the substrate (10).

3. Method according to Claim 1 or 2, wherein the first conductive track (16) is produced by etching a first conductive layer that is colaminated beforehand on the first face of the substrate and the layer of adhesive (13) is protected by an anti-adhesive film (15) during this etching.

4. Method according to Claim 3, including a step of depositing a finishing layer on the first conductive track (16) and a step of removing the anti-adhesive film (15) following the deposition of the finishing layer.

5. Method according to Claim 3 or 4, wherein the first conductive track (16) is etched into the first conductive layer (14), prior to the bonding, on the second face of the substrate, of the second conductive track (32), the latter being cut out beforehand from the conductive layer.

6. Method according to Claim 1 or 2, wherein the first conductive track (16) is produced by cutting out from a first conductive layer before being colaminated on the first face of the substrate (10).

7. Method according to one of the preceding claims, including a step of depositing a second conductive material (34) on at least one localized soldering zone (36) on a face of at least one of the first and second conductive tracks (16, 32).

8. Method according to Claim 7, wherein at least one localized soldering zone (36) is made to coincide with the hole (20) passing through the substrate.

9. Method according to Claim 7 or 8, including a step of depositing the second conductive material (34) on a face of one of the first and second conductive tracks (16, 32), opposite the face including the localized soldering zone (36).

10. Electrical circuit for producing at least one chip card (1), comprising a substrate (10) of dielectric material, not including magnetic material and having a first and a second main face (6, 7), and including a first electrically conductive track (16) on the first face, a second electrically conductive track (32) on the second face, having received a finishing layer, and at least one hole (20) passing through the substrate (10), **characterized in that** at least one of the first and second conductive tracks (16, 32) is formed of a conductive layer that is cut out beforehand and bonded, on one of the first and second main faces (6, 7) of the substrate (10), by way of a layer of adhesive (12 or 13) perforated coincidentally with the hole (20) passing through the substrate (10).

11. Electrical circuit according to Claim 10, wherein a second conductive material (34) is positioned on at least one localized soldering zone (36) on a face of the conductive track that is cut out beforehand.

12. Electrical circuit according to Claim 11, wherein at least one localized soldering zone (36) is situated facing the hole (20) passing through the substrate (10).

13. Electrical circuit according to Claim 11 or 12, wherein the first conductive track (16) is etched into a first conductive layer (14).

14. Electrical circuit according to Claim 11 or 12, wherein the first and second conductive tracks (16, 32) are cut out beforehand from a first and a second conductive layer, respectively.
